(19) Europäisches Patentamt
European Patent Office
Office européen des brevets

(11) **EP 3 994 735 B1**

(12) **EUROPÄISCHE PATENTSCHRIFT**

(45) Veröffentlichungstag und Bekanntmachung des Hinweises auf die Patenterteilung:
**23.08.2023 Patentblatt 2023/34**

(21) Anmeldenummer: **20734704.8**

(22) Anmeldetag: **23.06.2020**

(51) Internationale Patentklassifikation (IPC):
**H10N 30/00** (2023.01)    **H10N 30/853** (2023.01)
**H10N 30/076** (2023.01)

(52) Gemeinsame Patentklassifikation (CPC):
**H10N 30/1051; H10N 30/076; H10N 30/8554**

(86) Internationale Anmeldenummer:
**PCT/EP2020/067567**

(87) Internationale Veröffentlichungsnummer:
**WO 2021/004781 (14.01.2021 Gazette 2021/02)**

(54) **HALBLEITERBAUELEMENT MIT DIELEKTRISCHER SCHICHT**

SEMICONDUCTOR COMPONENT WITH DIELECTRIC LAYER

COMPOSANT SEMICONDUCTEUR COMPORTANT UNE COUCHE DIÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.07.2019 DE 102019209965**
**05.07.2019 DE 102019209964**
**08.07.2019 DE 102019210033**
**08.07.2019 DE 102019210032**

(43) Veröffentlichungstag der Anmeldung:
**11.05.2022 Patentblatt 2022/19**

(73) Patentinhaber: **Robert Bosch GmbH**
**70442 Stuttgart (DE)**

(72) Erfinder:
- **SCHARY, Timo**
**72631 Aichtal-Neuenhaus (DE)**
- **TOMASCHKO, Jochen**
**71126 Gaeufelden (DE)**
- **MONTEIRO DINIZ REIS, Daniel**
**73734 Esslingen am Neckar (DE)**
- **PANTEL, Daniel**
**71254 Ditzingen (DE)**
- **SCHATZ, Frank**
**70806 Kornwestheim (DE)**
- **MEWS, Mathias**
**72766 Reutlingen (DE)**

(56) Entgegenhaltungen:
**EP-A1- 3 306 687        JP-A- 2020 012 159**
**US-A1- 2011 074 889**

- **CHAKRABORTI P ET AL: "XPS depth profiling and leakage properties of anodized titania dielectrics and their application in high-density capacitors", JOURNAL OF MATERIAL SCIENCE, Bd. 50, Nr. 23, 6. August 2015 (2015-08-06), Seiten 7600-7609, XP035547978, ISSN: 0022-2461, DOI: 10.1007/S10853-015-9320-6**
- **MONTEIRO DINIZ REIS D ET AL: "Leakage Current in Low-Temperature PVD PZT Films", 2019 IEEE INTERNATIONAL SYMPOSIUM ON APPLICATIONS OF FERROELECTRICS, 14-19 JULY 2019, LAUSANNE, SWITZERLAND, 14. Juli 2019 (2019-07-14), Seiten 1-4, XP033740285, DOI: 10.1109/ISAF43169.2019.9034930**

**Beschreibung**

Die Erfindung betrifft ein Halbleiterbauelement gemäß Anspruch 1.

Stand der Technik

In "Improved reliability predictions in high permittivity dielectric oxide capacitors under high dc electric fields with oxygen vacancy induced electromigration" von C. A. Randall, R. Maier, W. Qu, K. Kobayashi, K. Morita, Y. Mizuno, N. Inoue und T. Oguni aus dem Journal of Applied Physics 113, 014101 (2013) wird als Grund für den Durchbruch in einer dielektrischen Schicht das Hopping einer in einer dielektrischen Schicht vorliegenden Defektart, wie beispielsweise Sauerstofffehlstellen, beschrieben. Die zentralen Modellparameter werden hierbei physikalisch motiviert, aber empirisch durch Fit an die Ausfallzeit unter der Annahme nur einer aktiven Defektart ermittelt. Wie diese Parameter genauer mit dem Material zusammenhängen wird nicht beschrieben. Komplexe Ausfallmechanismen, bei denen in der Halbleiterschicht mehrere Defektarten vorliegen, werden hierbei unvollständig oder überhaupt nicht abgebildet. Die dort beschriebene Lebensdauervorhersage gilt nur, wenn eine Defektart bei einem vorliegenden Lastfall mit einer bestimmten Temperatur und einem bestimmen elektrischen Feld dominiert und das Versagen auch ausschließlich durch die Anhäufung dieser einen Defektart an eine Grenzschicht verursacht wird.

Halbleiterbauelemente mit dielektrischen Schichten, aufweisend mindestens zwei Arten beweglicher Defekte, sind beispielsweise aus Chakraborti P et al, "XPS depth profiling and leakage properties of anodized titania dielectrics and their application in high-density capacitors", J. Mater. Sci. (2015) 50:7600-7609 ($TiO_2$-Schicht mit Ti- und O-Defekten) sowie US 2011/074889 A1 und EP 3 306 687 A1 (PZT-Schicht mit Pb- und O-Defekten) bekannt.

Es ist eine Aufgabe der vorliegenden Erfindung, die Lebensdauer eines Halbleiterbauelements mit mehr als einer aktiven Defektart unabhängig von dem Anwendungsfall (Betriebsspannung, Betriebstemperatur) dieses Halbleiterbauelements zu optimieren.

Offenbarung der Erfindung

Zur Lösung der Aufgabe wird ein Halbleiterbauelement gemäß Anspruch 1 vorgeschlagen. Dieses wird mit Hilfe von Dünnschichttechnologien auf Siliziumsubstraten hergestellt und kann beispielsweise als piezoelektrischer Aktor bei MEMS-Bauteilen, wie zum Beispiel Mikrospiegeln verwendet werden. Hierbei weist das Halbleiterbauelement wenigstens eine dielektrische Schicht auf. Außerdem weist das Halbleiterbauelement wenigstens eine erste und eine zweite Elektrode auf, über welche eine Betriebsspannung an die dielektrische Schicht angelegt wird. In der dielektrischen Schicht liegen außerdem wenigstens zwei voneinander unterschiedliche Defektarten mit vor. Diese können Fehlstellen (z.B. Sauerstoff- oder Bleifehlstellen), Gitterstörung durch besetzte Zwischengitterplätze (z.B. durch Wasserstoff), Frenkel-Defekte, aber auch substitutionelle Defekte (z.B. durch beabsichtigt oder unbeabsichtigt eingebrachte Fremdatome) sein. Diese Defektarten unterscheiden sich beispielsweise in ihrer elektrischen Ladungszahl voneinander. Die wenigstens zwei voneinander unterschiedlichen Defektarten sind dazu ausgebildet, sich in Abhängigkeit einer zwischen der ersten und zweiten Elektrode angelegten Betriebsspannung und einer vorliegenden Betriebstemperatur entlang lokalisierter Defektzustände mit einem jeweils gleichen, mittleren effektiven Abstand ao in Richtung einer der beiden Elektroden zu bewegen. Dieser Bewegungszustand der Defektarten wird auch als Hopping bezeichnet. Der mittlere effektive Abstand $a_0$ der lokalisierten Defektzustände ist hierbei eine aussagekräftige, mess- und beeinflussbare Materialeigenschaft, die die Qualität des Halbleiterbauelements im Hinblick auf die Lebensdauer am Ende des Herstellungsprozesses charakterisiert. Der mittlere effektive Abstand ao korreliert mit der Mobilität von Defekten in der dielektrischen Schicht. Halbleiterbauelemente mit einem vergleichsweise großem Abstand von Hopping-Zentren führen dazu, dass sich die unterschiedlichen Defektarten schlechter in der dielektrischen Schicht bewegen und sich somit langsamer an einer Grenzschicht anreichern und in Folge zu einem dielektrischen Durchbruch führen können. Ein mittlerer effektiver Abstand $a_0$ von größer als 3,2 nm hat sich hierbei als ein Wert erwiesen, der trotz mehrerer vorliegender Defektarten in der dielektrischen Schicht zu einer Lebensdaueroptimierung des Halbleiterbauelements unabhängig von dem zukünftigen Anwendungsfall und damit vorliegenden Betriebszuständen des Halbleiterbauelements führt. Insbesondere ergibt sich bei einem mittleren effektiven Abstand von ao=3,2 nm eine Ausfallzeit von in etwa 12 Stunden bei maximaler Spannung von 10V und maximaler Betriebstemperatur von 100 °C. Diese Ausfallzeit ist für den Dauerbetrieb eines PZT-Aktors für ein Produkt der Unterhaltungselektronik, wie beispielsweise einen Mikrospiegel, geeignet.

Bauelemente gemäß Anspruch 1 zeigen über den Belastungszeitraum bis zum dielektrischen Versagen einen zeitlichen Verlauf der Leckstromdichte $J_{TED}$, welche über die Gleichung der Thermionic-Emission-Diffusion Theorie nach Crowell and Sze

$$J_{TED} = \frac{q \cdot N_C \cdot v_R}{1 + \frac{v_R}{v_D}} \cdot e^{-\frac{\phi_B^{eff}}{k_B \cdot T}} \cdot \left[ e^{\frac{q \cdot U}{k_B \cdot T}} - 1 \right] \tag{1}$$

beschrieben wird. Hierbei repräsentiert q die Einheitsladung, $N_C$ die effektive Zustandsdichte im Leitungsband, $v_R$ die effektive Rekombinationsgeschwindigkeit, $v_D$ die effektive Diffusionsgeschwindigkeit, $\phi_B^{eff}$ die effektive Schottky-Barriere, $k_B$ die Boltzmannkonstante, T die Umgebungstemperatur und U die Potentialdifferenz über die dielektrische Schicht. U beschreibt also die an den beiden Elektroden des Halbleiterbauelements angelegte Betriebsspannung.

Verursacht wird der zeitliche Verlauf der Leckstromdichte durch die Veränderung der effektiven Schottky-Barriere $\phi_B^{eff}(t)$. Diese charakterisiert den Einfluss der beiden Grenzschichten, welche sich zwischen den beiden Elektroden und der dielektrischen Schicht befinden, auf die Leckstromdichte. Die effektive Schottky-Barriere wird im Folgenden kurz als $\phi(t)$ bezeichnet und beinhaltet alle Anteile von Halbleiter-Elektrodenmaterialübergang, Veränderungen durch die angelegte Betriebsspannung und Veränderungen durch Anlagerung von Defekten. Der Logarithmus der Leckstromdichte reduziert Gleichung (1) auf eine zeitliche Konstante K und einen zeitlich veränderlichen Term. Der zeitlich veränderliche Term spiegelt die Vorgänge im Materialinneren wieder, welche durch die Bewegungen aller mobilen im Material enthaltenen Defekte verursacht wird:

$$\ln(J_{TED}(t)) = \ln(K) - \frac{\Phi(t)}{k_B \cdot T} \cdot \text{ mit } K = \frac{q \cdot N_C \cdot v_R}{1 + \frac{v_R}{v_D}} \cdot \left[ e^{\frac{q \cdot U}{k_B \cdot T}} - 1 \right] \tag{2.1}$$

Die Bezeichnung Defekt schließt hierbei auch strukturelle Änderungen im Gefüge mit ein.

Die Verschiebung der Defekte führt bei Annäherung an die Elektroden zu Defektanhäufungen in der dielektrischen Schicht, welche in Veränderungen der effektiven Barrierenhöhe $\phi$ resultieren. Gleichung 2.1 aufgelöst nach $\phi$ führt zu

$$\Phi(t) = [\ln(K) - \ln(J_{TED}(t))] k_B T \tag{2.2}$$

Dieser zeitliche Verlauf der effektiven Barrierenhöhe infolge der Anlagerung von Defekten wird durch den Ansatz

$$\phi(t) = \phi^+(t) + \phi^-(t) = \phi_0^+ + \sum_i \Delta\phi_i^+(t) + \phi_0^- + \sum_i \Delta\phi_i^-(t) \tag{3.1}$$

$$\phi(t) = \phi_0 + \sum_i \Delta\phi_i^+(t) + \sum_i \Delta\phi_i^-(t) \qquad \text{mit } \phi_0 = \phi_0^+ + \phi_0^- \tag{3.2}$$

beschrieben. Es finden hierbei im Allgemeinen Anlagerungen und damit verbundene Änderungen der effektiven Schottky-Barriere an beiden Grenzschichten $\phi^+(t)$ und $\phi^-(t)$ statt. Die Indizes + und - kennzeichnen hierbei jeweils die Veränderungen an der Grenzschicht, welche den Übergang von Minoritärs- bzw. Majoritätsladungsträger in die dielektrische Schicht charakterisiert. Die Grenzschichten haben eine Ausgangsbarrierenhöhe $\phi_0$ und erfahren Barrierenhöhenänderungen $\Delta\phi_i$, verursacht durch eine Defektart i. Aufgrund der notwendigen Ladungsneutralität muss es immer Defektpaare beziehungsweise Defektansammlungen geben. Das heißt, bei Auftreten von Defekten mit negativer Ladung existieren ebenso Defekte mit positiver Ladung im Material. Deren jeweiligen Wirkungen sind über die Indizes + und - gekennzeichnet. Die Einzeldefekte bewegen sich im angelegten elektrischen Feld der Betriebsspannung entsprechend ihrer Ladung in entgegengesetzter Richtung. Defekte mit positiver Ladung wandern zur Elektrode mit negativem Potential und lagern sich in deren Nähe in der dielektrischen Schicht an. Defekte mit negativer Ladung bewegen sich zur Elektrode mit positivem Potential um sich wiederum in deren Nähe anzulagern.

Die Barrierenhöhenänderung $\Delta\phi_i$, welche durch Defektart i erzeugt wird, ist gekennzeichnet durch ihre Maximalhöhe $\delta\phi_i$, und einer charakteristischen Zeitkonstante $\tau_i$, in welcher sich die Barrierenhöhenänderung am stärksten verändert:

$$\Delta\phi_i^{+/-}(t) = \delta\phi_i^{+/-} \left( 1 - e^{\frac{t}{\tau^{+/-}}} \right). \tag{4}$$

Der Term $\left(1 - e^{\frac{t}{\tau^{+/-}}}\right)$ stellt dabei eine Näherung für die statistische Anlagerung einer im Material gegebenen Defektverteilung dar. Hierbei haben die positiven und negativen Maximalhöhen der Barrierenänderung $\delta\phi_i^+$ und $\delta\phi_i^-$ und die dazugehörigen Zeitkonstanten $\tau_i^+$ und $\tau_i^-$ unterschiedliche Größen, da es sich um unterschiedliche Defekte und unterschiedliche Grenzschichten handelt. Dies führt mit Formel (3.2) zu

$$\phi(t) = \phi_0 + \sum_i \delta\phi_i^{+/-} \left(1 - e^{\frac{t}{\tau_i^{+/-}}}\right) \tag{5}$$

und für den zeitlich veränderlichen Teil der Barrierenänderung zu

$$\Delta\phi(t) = \sum_i \delta\phi_i^{+/-} \left(1 - e^{\frac{t}{\tau_i^{+/-}}}\right) \tag{5.1}$$

Die Zeitkonstant $\tau_i^{+/-}$ wird durch die Mobilität der Defekte in der dielektrischen Schicht und den zurückzulegenden Weg in dieser Schicht definiert. Bei der Verlagerung im Inneren der dielektrischen Schicht muss Defektart i den Abstand $d_i$ des Schwerpunktes seiner Verteilung zur Grenzschicht zurücklegen. Zusammen mit Geschwindigkeit $v_i$ resultiert die charakteristische Zeitkonstante für den Anlagerungsprozess der Defektart i

$$\tau_i = \frac{d_i}{v_i} \tag{6}$$

Bauelemente gemäß Anspruch 1 zeichnen sich durch eine Verlagerung der Defekte im angelegten elektrischen Feld der Betriebsspannung über Hopping aus. Die Defektart i bewegt sich entlang lokalisierter Defektzustände mit einem mittleren effektiven Abstand $a_i$. Dies führt zu einer Hopping-Geschwindigkeit $v_i$, welche über den bekannten Ansatz von Variable Range Hopping beschrieben wird:

$$v_i = C_{0,i}(a_i) \, e^{-\frac{E_{A,0,i}}{k_B T}} \sinh\left(\frac{N_{q,i} \, a_i \, E}{k_B T}\right) \qquad \text{mit } E = \frac{U}{d} \tag{7}$$

$$C_{0,i}(a_i) = v_i \, a_i \, e^{-\frac{2 a_i}{\alpha}} \tag{7.1}$$

Hierbei repräsentiert $C_{0,i}(a_i)$ eine Funktion, die den Einfluss der örtlichen Defektverteilung darstellt. Hierbei bezeichnet, wie bei Variable Range Hopping üblich, die Sprungversuchsfrequenz $v_i$ die Frequenz, mit der ein Defekt gegen vorhandene Potentialbarrieren anläuft. Weiterhin ist die Sprungwahrscheinlichkeit des Defektes proportional dem Überlappintegral $e^{-\frac{2 a_i}{\alpha}}$ der Wellenfunktionen zweier wasserstoffartiger lokalisierter Defekte mit Abklinglänge $\alpha$ im Abstand $a_i$ der lokalisierten Defektzustände. Die mit der Betriebstemperatur zunehmende Hopping-Wahrscheinlichkeit wird über den Exponentialterm mit der material- und defektabhängigen wahren Aktivierungsenergie $E_{A,0,i}$ berücksichtigt. Die wahre Aktivierungsenergie $E_{A,0,i}$ bezeichnet hierbei eine von der Betriebsspannung und Betriebstemperatur unabhängige Aktivierungsenergie. Die gerichtete Absenkung der Energiebarrieren im Hopping-Prozess beschreibt der Sinus hyperbolicus, welcher das Produkt aus der mit dem Defekt i assoziierten Ladung $N_{q,i}$, dem mittleren lokalisierten Defektzentrenabstand $a_i$ und dem elektrischen Feld E enthält. Das elektrische Feld E resultiert aus angelegter Betriebsspannung U und der Dicke d der dielektrischen Schicht. Steigt der mittlere Abstand lokalisierter Defektzentren $a_i$ an, so reduziert sich ganz allgemein für den beschriebenen Fall von Defekt Hopping die Mobilität des Defektes i. Dielektrische Schichten mit großem $a_i$ zeichnen sich gegenüber dielektrischen Schichten mit kleinerem $a_i$ dadurch aus, dass sich in ihnen bei gleichen Betriebsbedingungen, das heißt gleicher Betriebsspannung U und gleicher Betriebstemperatur T, Defekte langsamer verschieben. Dies führt zu größeren Zeitkonstanten $\tau_i$ für die Anlagerung der Defekte an den Grenzschichten zwischen dielektrischer Schicht und Elektrode und zu langsameren Barrierehöhenänderungen $\Delta\phi_i$.

Bauteile gemäß Anspruch 1 sind dadurch gekennzeichnet, dass sich die in der dielektrischen Schicht enthaltenen n Defektarten über lokalisierte Defektzustände mit gleichem mittlerem Abstand ao bewegen und somit gilt:

$$a_1 = a_2 \ldots a_n = a_0 \qquad\qquad (8)$$

Dieser Abstand der lokalisierten Defektzustände lässt sich mit Kenntnis der zuvor beschriebenen physikalischen Modellierung aus Leckstrommessdaten $J_{TED}$ extrahieren. Der mittlere effektive Abstand stellt für das dielektrische Versagen unter Temperatur- und Spannungsbelastung eine zentrale Materialeigenschaft dar. Diese Materialeigenschaft ist unabhängig von Betriebsspannung und Betriebstemperatur und kann über den Herstellungsprozess beeinflusst werden. Diese Beeinflussung kann beispielsweise über die Wahl der Ausgangsmaterialien bei der Abscheidung der dielektrischen Schicht (z.B. Wahl des Sputter Targets) und/oder die Variation der Prozessbedingungen während der Materialabscheidung (z.B. Gase, Leistungen, Temperatur) und/oder auch über Folgeprozesse (z.B. thermische Behandlungen, Einwirken von Gasen) erfolgen. Beispielweise führt eine Erhöhung der Temperatur oder eine Reduktion der Wachstumsgeschwindigkeit durch geringere Plasmaleistung während der Abscheidung der dielektrischen Schicht zu einer höheren kristallinen Qualität. Zudem kommt es hierbei zu einer Reduzierung der Defektzentrendichte, was wiederum zu einer Erhöhung von $a_0$ führt. Das Kristallgefüge kann darüber hinaus durch Änderung der Target-Zusammensetzung als Prozessbedingung verändert werden. Eine Änderung der Target-Zusammensetzung von $Pb_{1.3}(Zr_{0.52}\,Ti_{0.48})O_3Ni_{0.005}$ zu $Pb_{1.3}(Zr_{0.52}\,Ti_{0.48})O_3$ führt beispielsweise im Anschluss auf das Aufwachsen der dielektrischen Schicht zu einer Erhöhung von ao im Ausgangsmaterial. Die Reduktion des Wasserstoffgehaltes als Prozessbedingung in Folgeprozessen wie z.B. der Abscheidung von Passivierungen in Wasserstoff-haltigen Plasmaprozessen führt ebenfalls zu einer Erhöhung von $a_0$. In solchen Prozessen kann beispielsweise der Wasserstoffgehalt durch die Verwendung eines Wasserstoff-ärmeren Precursors, das heißt beispielsweise durch die Verwendung von $N_2$ als Stickstoffquelle statt $NH_3$ bei der Abscheidung einer PECVD-SiN Passivierungen, reduziert werden. Eine weitere Möglichkeit der Reduktion von Wasserstoff in der Abscheidung von PECVD-Passivierungen zur Erhöhung von $a_0$ ist die Reduktion von Wasserstoffhaltige Gasflüssen oder die Verwendung eines Wasserstoff-armen Precursors. Darüber hinaus kann die dielektrische Schicht durch die Verwendung von Barrieren (z.B. gesputterte Metalloxide: RuO, TiO, AlOx usw.) vor Wasserstoffhaltigen Folgeprozessen geschützt werden um ao zu erhöhen.

Weiterhin kann grundsätzlich durch Reduktion der Temperaturbelastung als Prozessbedingung, wie beispielsweise durch die zeitliche Verkürzung von Temperaturbelastungen und/oder der Absenkung der verwendeten Temperaturen, in Folgeprozesse die Ausgasung von Wasserstoff aus umgebenden Schicht in die dielektrische Schicht hinein reduziert und damit $a_0$ vergrößert werden.

Bei Bauelementen gemäß Anspruch 1 existieren für die beiden Grenzschichten kritische Barrierenhöhen $\phi_{krit}^{+/-}$. Wird eine dieser Barrierenhöhen infolge einer der kritischen Barrierenhöhenänderungen $\Delta\phi_{krit}^{+/-}$ lokal zum Zeitpunkt $t_{krit}$ erreicht und überschritten, findet der dielektrische Durchbruch lokal statt. Das bedeutet, dass beim Erreichen von $\phi_{krit}^+$ der Durchbruch durch tunnelnde Minoritätsladungsträger (Fall 1) erfolgt:

$$\phi_{krit}^+ = \phi_0^+ + \Sigma_i\,\Delta\phi_i^+\,(t_{krit}) = \phi_0^+ + \Delta\phi_{krit}^+ \qquad mit\ \Delta\phi_{krit}^+ = \Sigma_i\,\Delta\phi_i^+\,(t_{krit}) \quad (9.1)$$

Beim Erreichen von $\phi_{krit}^-$ erfolgt der Durchbruch dagegen durch tunnelnde Majoritätsladungsträger (Fall 2):

$$\phi_{krit}^- = \phi_0^- + \Sigma_i\,\Delta\phi_i^-\,(t_{krit}) = \phi_0^- + \Delta\phi_{krit}^-\ mit\ \Delta\phi_{krit}^- = \Sigma_i\,\Delta\phi_i^-\,(t_{krit}) \qquad (9.2)$$

Bei lokalem Erreichen von $\phi_{krit}$ erfolgt eine lokale Zunahme der Stromdichte bis hin zur lokalen Zerstörung des Halbleiterbauelements. Dies ist im Verlauf der Leckstromdichte $J_{TED}$ zum Zeitpunkt $t = t_{krit}$ entweder durch einen kurzen Anstieg, gefolgt von einem unmittelbaren Rückfall (in <1s) auf den $J_{TED}$-Wert vor dem Anstieg oder einen bleibenden Sprung erkennbar. Im ersten Fall zerstört der Leitungspfad sich thermisch selber. Im zweiten Fall ist die zugeführte elektrische Leistung nicht ausreichend um den Leitungspfad vollständig zu zerstören. Nach Überschreiten von $t_{krit}$ verbleibt ein Halbleiterbauelement, welches lokal auf einer begrenzten Fläche zerstört ist. Mit fortschreitender Belastung bei $t > t_{krit}$ folgen immer weitere lokale dielektrische Durchbrüche, was schließlich zur vollständigen Zerstörung des Halbleiterbauelements führt. Der erste lokale Durchbruch stellt somit ein relevantes Maß für die Lebensdauer des Halbleiterbauelements dar.

Mit der physikalischen Beschreibung der Barrierenhöhenänderung (5) über Hopping-Transport der n Defektarten (6) und (7) kann somit aus zeitlichen Verläufen der Leckstromdichte (1) der mittlere effektive Abstand $a_0$ der lokalisierten Defektzustände ermittelt werden. Durch diese Messung von $a_0$ vor und nach einer Variation im Herstellungsprozess können Halbleiterbauelementen nach Anspruch 1 gezielt verbessert werden. Hierfür werden zunächst an einem Halbleiterbauelement die Leckstromverläufe $J_{TED}$ bis zum dielektrischen Durchbruch zum Zeitpunkt $t_{krit}$ bei mindestens zwei Betriebsspannungen $U_1$ und $U_2$ und gleich bleibender Temperatur aufgenommen. Daraufhin werden die oben beschriebenen Gleichungen (2.2) und (5) gleichgesetzt und aus einem numerischen Fit resultiert folgend aus dem zeitlichen Verlauf von $J_{TED}$ die Größe $\tau_i$ als Funktion der Betriebsspannung. Entsprechend der oben beschriebenen Formeln (6), (7) und (8) folgt für konstante Temperatur $T = T_0$ die Funktion der $\tau_i$ in Abhängigkeit des elektrischen Feldes E

$$\tau_i(E;\,T_0) = \frac{d_i}{C_{0,i}(a_0)\,e^{-\frac{E_{A,0,i}}{k_B T_0}}}\,\frac{1}{\sinh\left(\frac{N_{q,i}\,a_0}{k_B T_0}\,E\right)} = \widetilde{K}_i(a_0)\,\frac{1}{\sinh\left(\frac{N_{q,i}\,a_0}{k_B T_0}\,E\right)} \qquad (10.1)$$

Aus den aus Leckstrommessungen ermittelten charakteristischen Zeitkonstanten $\tau_i$ bei konstanter Temperatur $T = T_0$ und variierter Spannung $U_1 = E_1/d$, $U_2 = E_2/d$ können bei der Anwesenheit von $n > 1$ Defekten durch mathematischem Fit die Größen $N_{q,i}$ und $a_0$ aus den Gleichungen (10.1) bestimmt werden. Hierbei erhält man entsprechend der physikalischen Erwartung für $N_{q,i}$ ganzzahlige Vielfache der Elementarladung e. Die gemessenen $J_{TED}$ Verläufe unterliegen Fertigungsschwankungen und Toleranzen, welche durch die verwendete Messtechnik bedingt sind. Die Genauigkeit der aus diesen Messungen bestimmten Materialeigenschaften $a_0$, $C_{0,i}(a_0)$, $N_{q,i}$ und $E_{A,0,i}$ kann daher durch Erhöhung von Probenzahl und auch zusätzliche Messdaten bei mehr als zwei Spannungen verbessert werden.

Nach Änderung der Prozessbedingungen wird die Bestimmung von $a_0$ wiederholt, um den physikalischen Einfluss der Prozessänderung auf die Materialeigenschaft $a_0$ mit zentralem Einfluss auf die Defektmobilität zu zeigen.

Eine anschauliche graphische Darstellung resultiert wenn $\ln(\tau_i(E;T_0))$ über der elektischen Spannung aufgetragen wird. Aus (10.1) wird dabei

$$\ln(\tau_i(E;\,T_0)/sek) = \ln\widetilde{K}_i(a_0) - \ln\sinh\left(\frac{N_{q,i}\,a_0}{k_B T_0}\,E\right) \qquad (10.2)$$

Mit $\sinh x = \frac{1}{2}(e^x - e^{-x})$ und für große Argumente x kann mit $\lim_{x\to\infty}\sinh x = \frac{1}{2}e^x$ Gleichung (10.2) für große elektrische Felder E weiter vereinfacht werden zu

$$\ln(\tau_i(E;\,T_0)/sek) \approx \underbrace{\ln\left(\widetilde{K}_i(a_0) - \frac{1}{2}\right)}_{K_i(a_0)} - \underbrace{\frac{N_{q,i}\,a_0}{k_B T_0}}_{m_i}\,E = K_i(a_0) - m_i\,E \qquad (10.3)$$

Daher ergeben sich in einer graphischen Darstellung mit $\ln(\tau_i(E;T_0)/sek)$ als Funktion der Betriebsspannung für die i Defektarten Geraden mit den Steigungen $m_i$. Diese Steigungen $m_i$ sind bei gleichbleibender Temperatur $T_0$ mit Ausnahme einer bekannten Konstante $k_B T_0$ durch die Defektladung $N_{q,i}$ und den mittleren effektiven Abstand lokalisierter Defektzentren $a_0$ definiert. Für kleine E gilt (10.2) weiterhin, jedoch weicht dann der graphische Verlauf erkennbar von einer Geraden ab. Die Geraden sind in Gleichung (10.3) erkennbar entlang der Y-Achse durch $K_i(a_0)$ verschoben. $K_i(a_0)$ bezeichnet den in (7.1) beschriebenen spannungs- und temperaturunabhängigen lokalen Einfluss des mittleren effektiven Abstandes lokalisierter Defektzentren $a_0$ auf die Hopping-Geschwindigkeit.

Bevorzugt weist der mittlere effektive Abstand $a_0$ der dielektrischen Schicht des Halbleiterbauelements einen Wert von größer als 3,24 nm auf. Ein solches Material weist eine geringere Defektmobilität gegenüber Material mit einem mittleren effektiven Abstand von 3,2 nm auf. Dies wiederum führt zu einer erhöhten Lebensdauer des Halbleiterbauelements.

In der Praxis kommen häufiger dielektrische Schichten vor, in denen mehr als nur zwei unterschiedliche Defektarten vorliegen. Für den beispielhaften Fall einer PZT-Schicht liegen mindestens lokale Überschüsse oder Defizite der Atome Pb, Ti und Zr vor. Weiterhin kommen in der Praxis Betriebszustände vor, das heißt Kombinationen von Betriebstemperatur T und Betriebsspannung U, in welchen mehr als zwei Defekte einen relevanten Beitrag zum elektrischen Versagen der dielektrischen Schicht liefern. Bei den hierbei beschriebenen Halbleiterbauelementen können entsprechend eine höhere Anzahl von dielektrischen Schichten verwendet und innerhalb eines größeren Bereiches von Betriebsbedingungen betrieben werden.

Bevorzugt ist die dielektrische Schicht als ein polykristallines oxidisches high-k Dielektrika und insbesondere als PZT-Schicht (PZT = Pb[$Zr_x Ti_{1-x}$]$O_3$), dotierte PZT-Schicht (Pb($Zr_{xT} i_{1-x-y}$)$O_3 Ni_y$), KNN-Schicht (KNN = [$K_x Na_{1-x}$]$NbO_3$), $HfO_2$, $ZrO_2$ oder $SrTiO_3$ ausgebildet. Vorzugsweise weist die gesputterte PZT-Schicht des Halbleiterbauelements eine Zusammensetzung von $Pb_{1.3}$($Zr_{0.52} Ti_{0.48}$)$O_3$ oder $Pb_{1.3}$($Zr_{0.52} Ti_{0.48}$)$O_3 Ni_{0.005}$ auf. Bevorzugt können weiterhin zusätzliche Defekte über Dotierungen in die high-k Dielektrika eingebracht werden, um Barrierenhöhenänderungen $\Delta\Phi$ zu beeinflussen.

Vorzugsweise ist die dielektrische Schicht als gesputterte PZT-Schicht ausgebildet. Hierbei wird das sogenannte Target-Material in einem Plasma auf einem Substrat abgeschieden. Als Target-Material wird beispielsweise PZT verwendet. Bevorzugt weist die gesputterte PZT-Schicht in diesem Zusammenhang eine Abscheidetemperatur von kleiner als 500°C auf. Bei einer solchen dielektrischen Schicht kommt es nachweislich zu dem Effekt, dass je geringer die vorliegende Defektmobilität in der gesputterten PZT-Schicht, desto höher die Lebensdauer des Halbleiterbauelements ist.

Beschreibung der Zeichnungen

Figur 1a zeigt den Verlauf einer Leckstrommessung bei drei unterschiedlichen dielektrischen Schichten.

Figur 1b zeigt den aus einer Leckstrommessung resultierenden zeitlichen Verlauf der effektiven Barrierenhöhe und die Aufgliederung in die Beiträge der vorliegenden Defektarten.

Figur 2a zeigt den Verlauf von vier Leckstrommessungen und den jeweils angepassten Modellkurven ermittelt an einer dielektrischen Schicht bei gleicher Betriebstemperatur, jedoch unterschiedlichen Betriebsspannungen.

Figur 2b zeigt die Verläufe der Zeitkonstanten der beteiligten Defektarten in Abhängigkeit des elektrischen Feldes.

Figur 3 zeigt die Verläufe der Zeitkonstanten der beteiligten Defektarten in Abhängigkeit des elektrischen Feldes für drei verschiedene dielektrische Schichten.

Figur 4a bis 4d zeigt schematisch die Bewegung unterschiedlicher Defektarten in einer dielektrischen Schicht entlang lokalisierter Defektzustände mit jeweils einem mittleren effektiven Abstand ao.

Figur 5 zeigt die Veränderung der Ausfallzeiten $t_{krit}$ in Abhängigkeit des mittleren effektiven Abstandes der lokalisierten Defektzentren $a_0$ für vier dielektrische Schichten und zwei Betriebsbedingungen.

Figur 6a zeigt den Verlauf von drei Leckstrommessungen und den jeweils angepassten Modellkurven ermittelt an $Pb_{1.3}$($Zr_{0.52} Ti_{0.48}$)$O_3 Ni_{0.005}$ als dielektrische Schicht bei gleicher Betriebstemperatur, jedoch unterschiedlichen Betriebsspannungen.

Figur 6b zeigt die Verläufe der Zeitkonstanten der beteiligten Defektarten in Abhängigkeit des elektrischen Feldes.

Ausführungsformen der Erfindung

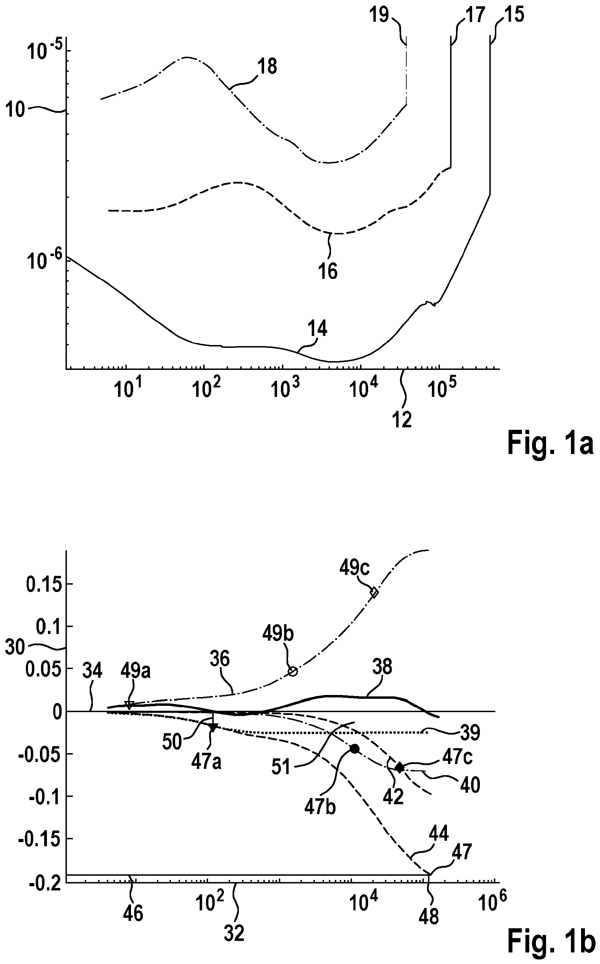

Figur 1a zeigt den Verlauf 14 einer Leckstrommessung einer dielektrischen Schicht eines Halbleiterbauelements, welches im Folgenden als Ausführungsbeispiel 1 bezeichnet wird. Auf der X-Achse 12 ist hierbei die Zeit logarithmisch mit der Einheit Sekunden und auf der Y-Achse 10 die Leckstromdichte in der Einheit Ampere pro Quadratzentimeter logarithmisch aufgetragen. Das für die Leckstrommessung vorgesehene Ausführungsbeispiel 1 wies ein Siliziumsubstrat mit dielektrischen Passivierungsschichten und einer darauf abgeschiedenen ersten Elektrode auf. Diese erste Elektrode wies eine Doppelschicht aus 110nm dickem PVD Platin auf, welche durch eine leitfähige 100nm Lanthan-Nickel-Oxid Pufferschicht (im Folgenden als LNO Schicht bezeichnet) abgedeckt wurde. Diese LNO Schicht wurde ebenfalls per PVD aufgebracht. Die auf der ersten Elektrode befindliche dielektrische Schicht wies eine Dicke von 1 $\mu$m auf und wurde in einem RF-PVD Prozess bei einer Temperatur von 480°C und einer Targetzusammensetzung von $Pb_{1.3}$($Zr_{0.52} Ti_{0.48}$)$O_3$ abgeschieden. Die restlichen Prozessparameter der zuvor beschriebenen Abscheidungen wurden so gewählt, dass die dielektrische Schicht polykristallin und bevorzugt mit einer (100) c-Achsenorientierung aufwächst. Die zweite Elektrode des Halbleiterelements, welche eine 110nm dicke Platinelektrode darstellte, wurde per PVD auf die dielektrische Schicht aufgebracht. Das Halbleiterbauelement entsprechend Ausführungsbeispiel 1 wurde passiviert und erfuhr nach der elektrischen Kontaktierung keine thermische Nachbehandlung.

Außerdem zeigt Figur 1a den Verlauf 16 einer Leckstrommessung einer dielektrischen Schicht eines weiteren Halbleiterbauelements, welches im Folgenden als Ausführungsbeispiel 2 bezeichnet wird.

Die Herstellung von Ausführungsbeispiel 2 erfolgte analog zu Ausführungsbeispiel 1, jedoch wurden die Bauelemente nach elektrischer Kontaktierung einer thermischen Nachbehandlung unterzogen. Diese erfolgte bei 450°C für 40 Minuten in 60 mbar Stickstoffatmosphäre.

Zudem zeigt Figur 1a den Verlauf 18 einer Leckstrommessung einer dielektrischen Schicht eines weiteren Halbleiterbauelements, welches im Folgenden als Ausführungsbeispiel 3 bezeichnet wird. Die Herstellung von Ausführungsbeispiel 3 erfolgte analog zu Ausführungsbeispiel 1, jedoch wurden die Bauelemente nach elektrischer Kontaktierung einer thermischen Nachbehandlung unterzogen. Diese erfolgte bei 500°C für 40 Minuten in 60 mbar Stickstoffatmosphäre.

Vor der Messung der Leckstromverläufe wurden alle beschriebenen Ausführungsbeispiele 1, 2 und 3 mit Passivierungsschichten abgedeckt und mit Aluminiumleiterbahnen elektrisch kontaktiert.

Alle drei Ausführungsbeispiele wurden bis zum jeweiligen dielektrischen Durchbruch 15, 17 und 19 gemessen. Wie hierbei zu erkennen ist, ergeben sich abhängig von der Herstellung einer dielektrischen Schicht sehr unterschiedliche Leckstromverläufe 14, 16 und 18 mit unterschiedlichen Durchbruchszeiten 15, 17 und 19.

Figur 1b zeigt beispielhaft das Extrahieren von Modellgrößen anhand des auf Figur 1a gemessenen Leckstromverlaufs 16 an Ausführungsbeispiel 2. Auf der X-Achse 32 ist hierbei wiederum die Zeit logarithmisch mit der Einheit Sekunden und auf der Y-Achse 30 die Barrierenhöhenänderung $\Delta\phi$ mit der Einheit Elektronenvolt logarithmisch aufgetragen. Der Verlauf 38 zeigt hierbei den in Abhängigkeit von der Zeit ermittelten Verlauf der Barrierenhöhenänderung $\Delta\phi(t)$ ausgehend von einer Ausgangsbarrierenhöhe $\phi_0$ 34.

Dieser Verlauf 38 der Barrierenhöhenänderung $\Delta\phi(t)$ wird ermittelt durch die Formel (siehe obige Formel 2.2):

$$\Phi(t) = [\ln(K) - \ln(J_{TED}(t))]k_B T$$

Darauf folgend wird der ermittelte zeitliche Verlauf der mittleren effektiven Barrierenhöhe $\phi(t)$ numerisch auf die Formel (siehe obige Formel 3.2) angepasst:

$$\phi(t) = \phi_0 + \sum_i \Delta\phi_i^+(t) + \sum_i \Delta\phi_i^-(t)$$

Man erhält aus diesem numerischen Fit entsprechend unterschiedliche $\Delta\phi_i^{+/-}(t)$, die den Verlauf von $\Delta\phi(t)$ beschreiben. So wird in dem gezeigten Fall $\Delta\phi(t)$ 38 durch den Verlauf von $\Delta\phi_a^-(t)$ 39, den Verlauf von $\Delta\phi_b^-(t)$ 40 und den Verlauf von $\Delta\phi_c^-(t)$ 42 zusammen mit dem Summenverlauf $\sum_i \Delta\phi_i^+$ 36 beschrieben. Entsprechend der folgenden Formel (siehe obige Formel 5.1)

$$\Delta\phi(t) = \sum_i \delta\phi_i^{+/-}\left(1 - e^{\frac{t}{\tau_i^{+/-}}}\right)$$

können dann die unterschiedlichen $\tau_i^{+/-}$ ermittelt werden. Man erhält in diesem Fall für die den Majoritätsladungsträgern zugeordneten Barrierenhöhenänderungen $\Delta\phi_i^-$ 39, 40 und 42 eine zugehörige charakteristische Zeitkonstante $\tau_a$, $\tau_b$ und $\tau_c$. Diese sind in Figur 1b jeweils gekennzeichnet durch 47a, 47b und 47c und stellen den Zeitpunkt dar, zu welchem sich die entsprechende Barrierenhöhenänderung am stärksten verändert. Die Barrierenhöhenänderungen für die Minoritätsladungsträger $\Delta\phi_i^+$ wurden zur Verbesserung der Übersicht nicht explizit einzeln dargestellt. Gezeigt ist lediglich deren Summenverlauf $\sum_i \Delta\phi_i^+$ 36 mit den einzelnen Zeitkonstanten $\tau_d$, $\tau_e$ und $\tau_f$ 49a, 49b und 49c. Eine jeweilige charakteristische Zeitkonstante ist hierbei einer in der Schicht vorliegenden Defektart a, b, c, d, e und f zugeordnet und entsprechend liegen in dieser dielektrischen Schicht sechs zueinander unterschiedliche Defektarten vor.

In dem auf Figur 1b dargestellten Fall erfolgt der dielektrische Durchbruch 47 der dielektrischen Schicht durch tunnelnde Majoritätsladungsträger entsprechend der folgenden Formel (siehe obige Formel 9.2):

$$\phi_{krit}^- = \phi_0^- + \sum_i \Delta\phi_i^-(t_{krit}) = \phi_0^- + \Delta\phi_{krit}^- \qquad mit\ \Delta\phi_{krit}^- = \sum_i \Delta\phi_i^-(t_{krit})$$

Die zuvor ermittelten Verläufe von $\Delta\phi_a^-(i)$ 39, $\Delta\phi_b^-(t)$ 40 und $\Delta\phi_c^-(t)$ 42 werden also aufsummiert und führen entsprechend ihres Verlaufs zu Barrierenhöhenänderungen $\Sigma_i \, \Delta\phi_i^-$ 44. Wird hierbei zu dem Zeitpunkt $t_{krit}$ 48 die für die Majoritätsladungsträger kritische Barrierenhöhenänderung $\Delta\phi_{krit}^-$ 46 der dielektrischen Schicht erreicht, kommt es infolge der unterschiedlichen vorliegenden Defektarten a, b und c, welche sich an einer Grenzschicht zwischen dielektrischer Schicht und Elektrode angelagert haben, zu einem lokalen Durchbruch der Schicht.

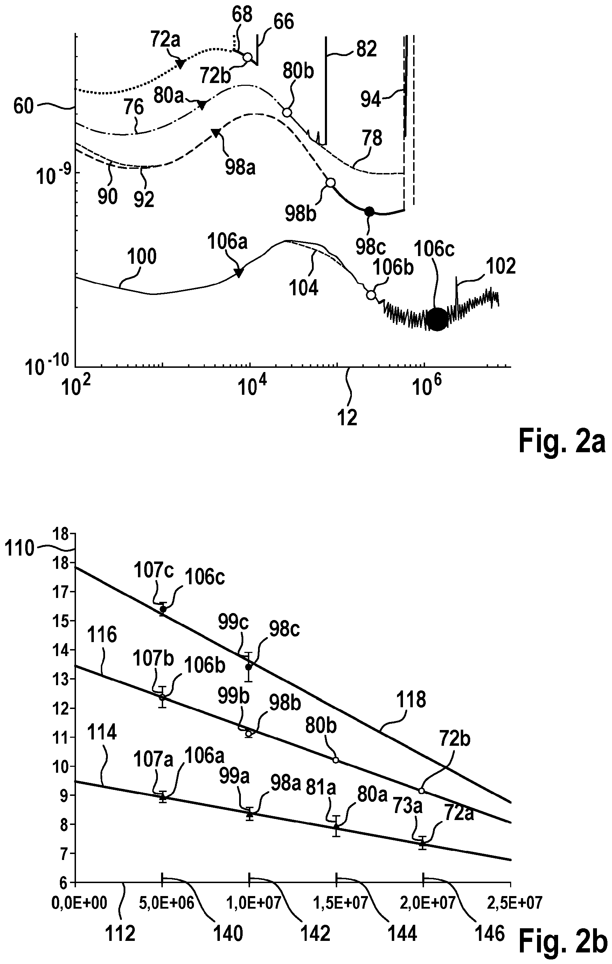

Figur 2a zeigt den am Ausführungsbeispiel 2 gemessenen Verlauf des Leckstroms bei unterschiedlichen Betriebsspannungen und konstanter Betriebstemperatur von 100°C. Auch hierbei ist auf der X-Achse 62 die Zeit logarithmisch in der Einheit Sekunden und auf der Y-Achse 60 die Leckstromdichte in der Einheit Ampere logarithmisch aufgetragen. Der Leckstromverlauf 100 wurde bei einer Betriebsspannung von 5 Volt, der Verlauf 92 bei einer Betriebsspannung von 10 Volt, der Verlauf 76 bei einer Betriebsspannung von 15 Volt und der Verlauf 68 bei einer Betriebsspannung von 20 Volt gemessen. Die Messungen wurden bis zu einem jeweiligen dielektrischen Durchbruch 66, 82, 94 und 102 der dielektrischen Schicht durchgeführt. Die gute Übereinstimmung von der angewandten Thermionic-Emission-Diffusion Theorie, sowie einer durch mobile Defekte zeitlich veränderlichen effektiven Barrierenhöhe mit den Messkurven, ist durch den Vergleich der gemessenen Stromverläufe 76, 92 und 100 mit den zugehörigen Modellkurven 78, 90 und 104 erkennbar.

Die in dem Leckstromverlauf 100 gekennzeichneten Punkte 106a, 106b und 106c stellen die, gemäß des auf Figur 1a und 1b beschriebenen Verfahrens, ermittelten charakteristischen Zeitkonstanten $\tau_a$, $\tau_b$ und $\tau_c$ für diesen Verlauf dar. Entsprechend stellen die in dem Leckstromverlauf 92 gekennzeichneten Punkte 98a, 98b und 98c die ermittelten charakteristischen Zeitkonstanten $\tau_a$, $\tau_b$ und $\tau_c$ für diesen Verlauf dar. Des Weiteren stellen die in dem Leckstromverlauf 76 gekennzeichneten Punkte 80a und 80b die ermittelten charakteristischen Zeitkonstanten $\tau_a$ und $\tau_b$ für diesen Verlauf dar. Die in dem Leckstromverlauf 68 gekennzeichneten Punkte 72a und 72b stellen die ermittelten charakteristischen Zeitkonstanten $\tau_a$ und $\tau_b$ für diesen Verlauf dar. Jeder charakteristischen Zeitkonstante $\tau_a$, $\tau_b$ und $\tau_c$ ist bei den vorliegenden Messungen jeweils einer der in der dielektrischen Schicht vorliegende Defektart a, b und c zugeordnet.

Figur 2b zeigt die Verläufe des Logarithmus der Zeitkonstanten $\tau_i$ der vorliegenden Defektarten geteilt durch Sekunden in Abhängigkeit des elektrischen Feldes. Auf der X-Achse 112 ist hierbei das elektrische Feld in der Einheit Volt pro Meter und auf der Y-Achse 110 ist der natürliche Logarithmus der charakteristischen Zeitkonstanten $\tau_i$ einheitenlos aufgetragen. Der X-Achsenabschnitt 140 kennzeichnet hierbei das elektrische Feld, welches bei einer Betriebsspannung von 5 Volt an der dielektrischen Schicht anliegt. In einer Vertikalen durch diesen Achsenabschnitt 140 finden sich entsprechend die aus Figur 2a identifizierten charakteristischen Zeitkonstanten 106a, 106b und 106c des Leckstromverlaufs 100 mit der jeweiligen Streubreite der Messdaten 107a, 107b und 107c wieder. Der X-Achsenabschnitt 142 kennzeichnet das elektrische Feld, welches bei einer Betriebsspannung von 10 Volt an der dielektrischen Schicht anliegt. In einer Vertikalen durch diesen Achsenabschnitt 142 finden sich entsprechend die aus Figur 2a identifizierten charakteristischen Zeitkonstanten 98a, 98b und 98c des Leckstromverlaufs 92 mit der jeweiligen Streubreite der Messdaten 99a, 99b und 99c wieder. Der X-Achsenabschnitt 144 kennzeichnet das elektrische Feld, welches bei einer Betriebsspannung von 15 Volt an der dielektrischen Schicht anliegt. In einer Vertikalen durch diesen Achsenabschnitt 144 finden sich entsprechend die aus Figur 2a identifizierten charakteristischen Zeitkonstanten 80a und 80b des Leckstromverlaufs 76 mit der jeweiligen Streubreite der Messdaten 81a wieder. Der X-Achsenabschnitt 146 kennzeichnet das elektrische Feld, welches bei einer Betriebsspannung von 20 Volt an der dielektrischen Schicht anliegt. In einer Vertikalen durch diesen Achsenabschnitt 146 finden sich entsprechend die aus Figur 2a identifizierten charakteristischen Zeitkonstanten 72a und 72b des Leckstromverlaufs 68 mit der jeweiligen Streubreite der Messdaten 73a wieder.

Entsprechend der oben hergeleiteten Formel (10.3)

$$\ln(\tau_i(E; T_0)/sek) \approx \underbrace{\ln\left(\widetilde{K}_i(a_o) - \frac{1}{2}\right)}_{K_i(a_0)} - \underbrace{\frac{N_{q,i} \, a_0}{k_B T_0}}_{m_i} E = K_i(a_0) - m_i$$

ergeben sich für die Defektarten a, b und c Geraden 114, 116 und 118 mit den Steigungen $m_a$, $m_b$, und $m_c$, welche für ein konstantes ao ganzzahlige Defektladungen $N_{q,a}$, $N_{q,b}$ und $N_{q,c}$ ergeben. Die Geraden 114, 116 und 118 sind entlang der Y-Achse verschoben durch die von ao abhängigen Konstanten $K_a$, $K_b$ und $K_c$.

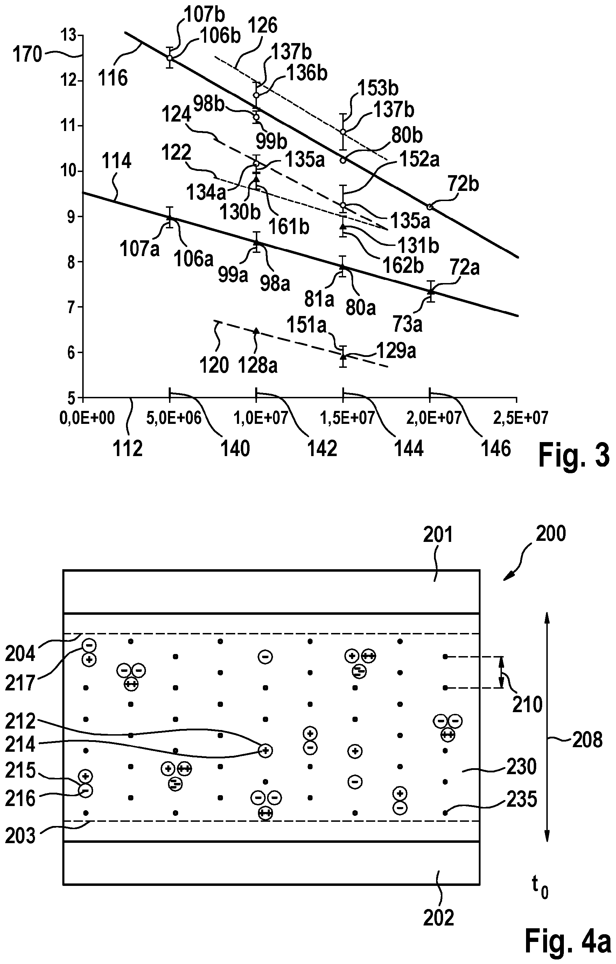

Figur 3 zeigt die Verläufe des Logarithmus der Zeitkonstanten der vorliegenden Defektarten in Abhängigkeit des elektrischen Feldes für drei dielektrische Schichten bei 100°C. Auf der X-Achse 112 ist hierbei das elektrische Feld in der Einheit Volt pro Meter und auf der Y-Achse 170 ist der natürliche Logarithmus der charakteristischen Zeitkonstanten einheitenlos aufgetragen. Der X-Achsenabschnitt 142 kennzeichnet das elektrische Feld, welches bei einer Betriebsspannung von 10 Volt an den dielektrischen Schichten anliegt. In einer Vertikalen durch diesen Achsenabschnitt 142 finden sich entsprechend Figur 2b die identifizierten charakteristischen Zeitkonstanten $\tau_a$, 98a und $\tau_b$ 98b mit der zugehörigen Streubreite der Messdaten 99a und 99b für das Ausführungsbeispiel 2 wieder. Ebenso finden sich in einer Vertikalen zu dem Achsenabschnitt 142 die identifizierten charakteristischen Zeitkonstanten $\tau_a$ 128a und $\tau_b$ 134a mit

der zugehörigen Streubreite der Messdaten 135a für das Ausführungsbeispiel 3 wieder. Zudem finden sich in einer Vertikalen zu dem Achsenabschnitt 142 die identifizierten charakteristischen Zeitkonstanten $\tau_a$ 130b und $\tau_b$ 136b mit der zugehörigen Streubreite der Messdaten 161b und 137b für das Ausführungsbeispiel 1 wieder. Der X-Achsenabschnitt 144 kennzeichnet das elektrische Feld, welches bei einer Betriebsspannung von 15 Volt an den dielektrischen Schichten anliegt. In einer Vertikalen durch diesen Achsenabschnitt 144 finden sich entsprechend Figur 2b die identifizierten charakteristischen Zeitkonstanten $\tau_a$ 80a und $\tau_b$ 80b mit der zugehörigen Streubreite der Messdaten 81a für das Ausführungsbeispiel 2 wieder. Ebenso finden sich in einer Vertikalen zu dem Achsenabschnitt 144 die identifizierten charakteristischen Zeitkonstanten $\tau_a$ 129a und $\tau_b$ 135a mit der zugehörigen Streubreite der Messdaten 151a und 152a für das Ausführungsbeispiel 3 wieder. Zudem finden sich in einer Vertikalen zu dem Achsenabschnitt 144 die identifizierten charakteristischen Zeitkonstanten $\tau_a$ 131b und $\tau_b$ 137b mit der zugehörigen Streubreite der Messdaten 162b und 153b für das Ausführungsbeispiel 1 wieder. Für die Defektart a resultiert für Ausführungsbeispiel 3 die Gerade 120, für Ausführungsbeispiel 2 die Gerade 114 und für Ausführungsbeispiel 1 die Gerade 122. Jede dieser Geraden 114, 120 und 122 weist eine unterschiedliche Steigung $m_a$ und eine Verschiebung entlang der Y-Achse $K_a(a_0)$ auf, welche durch einen jeweils unterschiedlichen mittleren effektiven Abstand $a_0$ bedingt wird. Für die Defektart b resultiert für Ausführungsbeispiel 3 die Gerade 124, für Ausführungsbeispiel 2 die Gerade 116 und für Ausführungsbeispiel 1 die Gerade 126. Jede dieser Geraden 116, 124 und 126 weist ebenfalls eine unterschiedliche Steigung $m_b$ und eine Verschiebung entlang der Y-Achse $K_b(a_0)$ auf, welche durch einen jeweils unterschiedlichen mittleren effektiven Abstand ao bedingt wird.

Figur 4a zeigt schematisch ein Halbleiterbauelement 200 zu einem ersten Zeitpunkt $t_0$. Das Halbleiterbauelement 200 umfasst hierbei eine dielektrische Schicht 230 mit einer Schichtdicke 208. Bei der dielektrischen Schicht 230 kann es sich beispielsweise um eine PZT-Schicht handeln. Zudem weist das Halbleiterbauelement 200 eine erste Elektrode 202 und eine zweite Elektrode 201 auf, die gegenüberliegend zueinander angeordnet sind. Zwischen einer jeweiligen Elektrode 201 oder 202 und der dielektrischen Schicht 230 ist zudem eine Grenzschicht 203 oder 204 angeordnet. In der dielektrischen Schicht 230 liegen unterschiedliche Defektarten vor, welche hier beispielhaft als Defektart 212 mit einfach positiver Ladung 214 und den Defektarten 215 und 217 mit einfach negativer Ladung 216 gekennzeichnet sind. Die Indizes + und - kennzeichnen hierbei jeweils die Anzahl der Ladungsträger einer entsprechenden Defektart. Aufgrund der notwendigen Ladungsneutralität in der dielektrischen Schicht 230 sind Defektpaare beziehungsweise Defektansammlungen vorhanden. Das heißt, bei Auftreten von Defekten mit negativer Ladung 215 und 217 existieren ebenso Defekte mit positiver Ladung 212 im Material. Die unterschiedlichen Defektarten 212, 215 und 217 sind auf lokalisierten Störstellen 235 angeordnet. Zu dem auf Figur 4a dargestellten ersten Zeitpunkt $t_0$ ist noch keine Spannung zwischen den Elektroden 201 und 202 und somit auch kein elektrisches Feld angelegt.

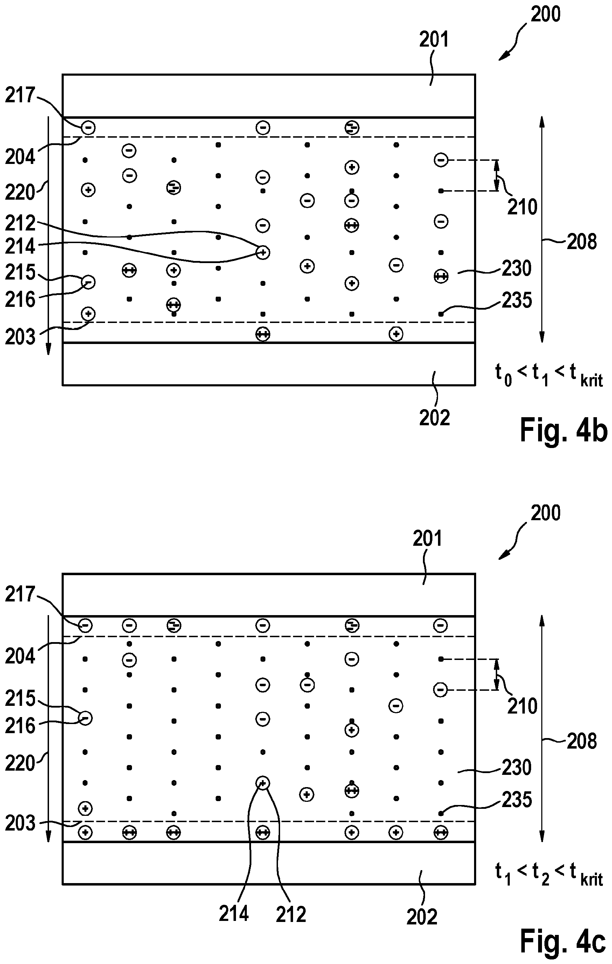

Figur 4b zeigt das Halbleiterbauelement 200 zu einem auf den ersten Zeitpunkt to folgenden zweiten Zeitpunkt $t_1$. Zu diesem Zeitpunkt $t_1$ ist eine Spannung zwischen der ersten Elektrode 202 und der zweiten Elektrode 201 angelegt und somit wird ein elektrisches Feld 220 in der dielektrischen Schicht 230 erzeugt. Die unterschiedlichen Defektarten 212, 215 und 217 bewegen sich nun in Abhängigkeit der zwischen der ersten 201 und zweiten Elektrode 202 angelegten Betriebsspannung und einer vorliegenden Betriebstemperatur entlang der lokalisierten Defektzustände 235. Dieser Bewegungszustand der Defektarten 212, 215 und 217 wird auch als Hopping bezeichnet. Die lokalisierten Defektzustände 235 weisen jeweils einen gleichen mittleren effektiven Abstand ao 210 auf. In diesem Fall ist der mittlere effektive Abstand ao 210 größer als 3,2nm. Defektarten 212 mit positiver Ladung 214 wandern zur Elektrode mit negativem Potential (in diesem Fall der ersten Elektrode 202) und lagern sich in der dortigen Grenzschicht 203 an. Defektarten 215 und 217 mit negativer Ladung 216 bewegen sich dagegen zur Elektrode mit positivem Potential (in diesem Fall der zweiten Elektrode 201), um sich in der dortigen Grenzschicht 204 anzulagern. Ladungsträger des Leckstromes $J_{TED}$, welche von einer zu der anderen Elektrode gelangen wollen, müssen Schottky-Barrieren $\phi(t)$ überwinden, welche durch die Grenzschichten 203 und 204 beeinflusst werden. Diese Barrieren haben eine Ausgangsbarrierenhöhe $\phi_0$ und erfahren durch die sich dort ansammelnden Defektarten Barrierenhöhenänderungen $\Delta\phi_i$.

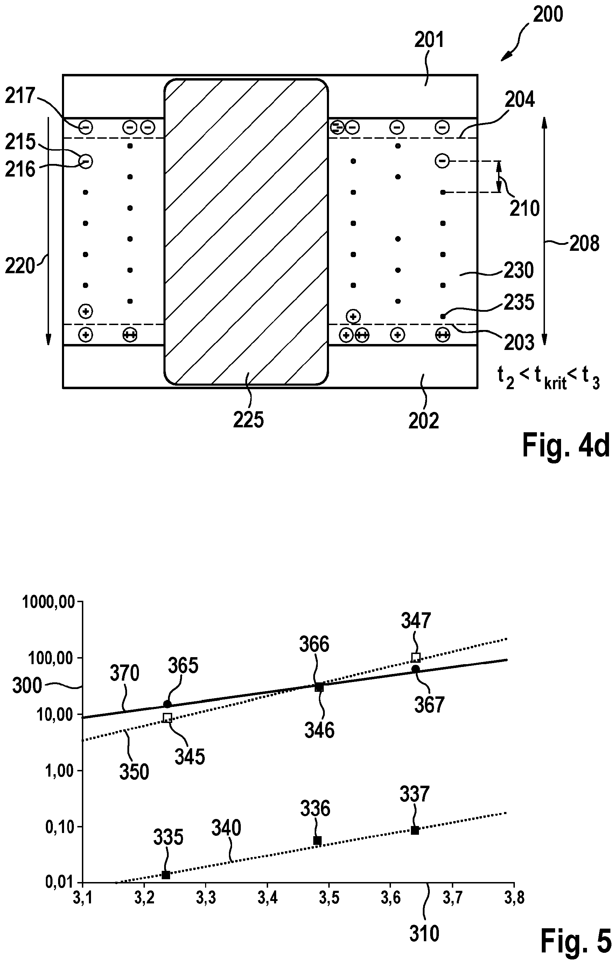

Figur 4c zeigt das Halbleiterbauelement 200 zu einem auf den zweiten Zeitpunkt $t_1$ folgenden dritten Zeitpunkt $t_2$. Hierbei haben sich schon ein Mehrzahl der unterschiedlichen Defektarten 212, 215 und 217 an den Grenzschichten 202 und 203 der dielektrischen Schicht 230 angesammelt und dort für Barrierenhöhenänderungen $\Delta\phi_i$ gesorgt. Zu einem auf den dritten Zeitpunkt folgenden vierten Zeitpunkt $t_3$ wird eine kritische Barrierenhöhe $\phi_{krit}$ an einer der Grenzschichten 202 oder 203 erreicht. Wie auf Figur 4d zu erkennen ist, kommt es hierbei nun zu einem lokalen dielektrischen Durchbruch 225 der dielektrischen Schicht 230. Nach Überschreiten von $t_{krit}$ verbleibt ein Halbleiterbauelement 200, welches lokal auf einer begrenzten Fläche zerstört ist. Mit fortschreitender Belastung bei $t > t_{krit}$ folgen immer weitere lokale dielektrische Durchbrüche 225, was schließlich zur vollständigen Zerstörung des Halbleiterbauelements 200 führt.

Figur 5 zeigt die Veränderung der Ausfallzeiten $t_{krit}$ in Abhängigkeit des mittleren effektiven Abstandes $a_0$ der lokalisierten Defektzentren für drei dielektrische Schichten und drei Betriebsbedingungen. Auf der Y-Achse 300 ist exponentiell die Ausfallzeit $t_{krit}$ mit der Einheit Stunden (h) und auf der X-Achse ist linear der mittlere effektive Abstand $a_0$ in der Einheit Nanometer (nm) aufgetragen. Die Markierung 335 kennzeichnet die ermittelte Ausfallzeit $t_{krit}$=46s für Ausführungsbeispiel 3 bei einem vorliegenden ao von 3,24nm und einer Betriebsspannung von -20Volt, sowie einer Betriebstemperatur von 150°C. Die Markierung 336 kennzeichnet die ermittelte Ausfallzeit $t_{krit}$=192s für Ausführungs-

beispiel 2 bei einem vorliegenden ao von 3,49nm und einer Betriebsspannung von -20Volt, sowie einer Betriebstemperatur von 150°C. Die Markierung 337 kennzeichnet die ermittelte Ausfallzeit $t_{krit}$=305s für Ausführungsbeispiel 1 bei einem vorliegenden ao von 3,65nm und einer Betriebsspannung von -20Volt, sowie einer Betriebstemperatur von 150°C.

Durch Verbinden der Markierungen 335, 336 und 337 erhält man eine Gerade 340, die zu erkennen gibt, wie sich der mittlere effektive Abstand ao durch entsprechend unterschiedliche Wärmebehandlung der Ausführungsbeispiele verändern lässt und dass ein größerer mittlerer effektiver Abstand $a_0$ auch zu größeren Ausfallzeiten $t_{krit}$ führt.

Die Markierung 345 kennzeichnet die ermittelte Ausfallzeit $t_{krit}$=2,95*10^4 s für Ausführungsbeispiel 3 bei einem vorliegenden ao von 3,24nm und einer Betriebsspannung von -2,5Volt, sowie einer Betriebstemperatur von 175°C. Die Markierung 346 kennzeichnet die ermittelte Ausfallzeit $t_{krit}$=1,11*10^5 s für Ausführungsbeispiel 2 bei einem vorliegenden ao von 3,49nm und einer Betriebsspannung von -2,5Volt, sowie einer Betriebstemperatur von 175°C. Die Markierung 347 kennzeichnet die ermittelte Ausfallzeit $t_{krit}$=3,99*10^5 s für Ausführungsbeispiel 1 bei einem vorliegenden ao von 3,65nm und einer Betriebsspannung von -2,5Volt, sowie einer Betriebstemperatur von 175°C.

Die Markierungen 345, 346 und 347 weisen aufgrund der unterschiedlichen Betriebsbedingungen gegenüber 335, 336 und 337 wesentlich höhere Ausfallzeiten auf. Jedoch ergibt sich auch hier durch Verbinden der Markierungen 345, 346 und 347 eine Gerade 350, die den zuvor schon beschriebenen Zusammenhang bestätigt und somit zeigt, dass der Zusammenhang zwischen mittlerem effektiven Abstand $a_0$ und Ausfallzeit $t_{krit}$ unabhängig von den vorliegenden Betriebsbedingungen gilt.

Die Markierung 365 kennzeichnet die ermittelte Ausfallzeit $t_{krit}$=5,25*10^4 s für Ausführungsbeispiel 3 bei einem vorliegenden ao von 3,24nm und einer Betriebsspannung von -10Volt, sowie einer Betriebstemperatur von 100°C. Die Markierung 366 kennzeichnet die ermittelte Ausfallzeit $t_{krit}$=1,1*10^5 s für Ausführungsbeispiel 2 bei einem vorliegenden ao von 3,49nm und einer Betriebsspannung von -10Volt, sowie einer Betriebstemperatur von 100°C. Die Markierung 367 kennzeichnet die ermittelte Ausfallzeit $t_{krit}$=2,42*10^5 s für Ausführungsbeispiel 1 bei einem vorliegenden ao von 3,65nm und einer Betriebsspannung von -10Volt, sowie einer Betriebstemperatur von 100°C.

Die Markierungen 365, 366 und 367 ergeben nach Verbinden eine Gerade 370, die den zuvor beschriebenen Zusammenhang erneut bestätigt und somit zeigt, dass der Zusammenhang zwischen mittlerem effektiven Abstand ao und Ausfallzeit $t_{krit}$ unabhängig von den vorliegenden Betriebsbedingungen gilt. Bei $a_0$=3,2 nm ergibt sich in Bezug auf die Gerade 370 eine Ausfallzeit von 12 Stunden. Für die Auslegung eines PZT-Aktors ist ein Dauerbetrieb über 12 Stunden bei maximaler Spannung von 10V und maximaler Betriebstemperatur von 100°C eine praxisnahe Anforderung für ein Produkt der Unterhaltungselektronik (beispielsweise einen Mikrospiegel).

Für die geprüften Ausführungsbeispiele 1, 2 und 3 konnten jeweils drei verschiedene Defektarten a, b und c identifiziert werden, die für die Beiträge $\Sigma_i \Delta\phi i^-$ verantwortlich sind. Zum einen die Defektart a mit einer vorliegenden Ladung von 1e und einer vorliegenden wahren Aktivierungsenergie von 0,92eV. Diese Defektart kann in den vorliegenden Ausführungsbeispielen mit Wasserstoff bzw. OH-Gruppen im Inneren der dielektrischen Schicht assoziiert werden. Zum anderen die Defektart b mit einer vorliegenden Ladung von 3e und einer vorliegenden wahren Aktivierungsenergie von 0,95eV. Diese Defektart kann in den vorliegenden Ausführungsbeispielen mit Blei und/oder Titan im Inneren der dielektrischen Schicht assoziiert werden. Die Defektart c weist eine vorliegende Ladung von 4e und eine wahren Aktivierungsenergie 0,855eV auf. Diese Defektart kann in den vorliegenden Ausführungsbeispielen mit Blei, Titan und/oder Zirkon im inneren der dielektrischen Schicht assoziiert werden.

Für die geprüften Ausführungsbeispiele 1, 2 und 3 konnten außerdem jeweils drei verschiedene Defektarten d, e und f identifiziert werden, die für die Beiträge $\Sigma_i \Delta\phi_i^+$ verantwortlich sind. Zum einen die Defektart d mit einer Ladung von 1e und einer vorliegenden wahren Aktivierungsenergie von kleiner als 0,8eV. Diese Defektart kann in den vorliegenden Ausführungsbeispielen mit Wasserstoff im Inneren der dielektrischen Schicht assoziiert werden. Zum andere die Defektart e mit einer vorliegenden Ladung von 2e und einer vorliegenden wahren Aktivierungsenergie von 1,04eV. Diese Defektart kann in den vorliegenden Ausführungsbeispielen mit Sauerstoff bzw. Blei im inneren der dielektrischen Schicht assoziiert werden. Die Defektart e weist eine vorliegende Ladung von 2e und eine wahre Aktivierungsenergie 1,22eV auf. Diese Defektart kann in den vorliegenden Ausführungsbeispielen mit Blei im Inneren der dielektrischen Schicht assoziiert werden.

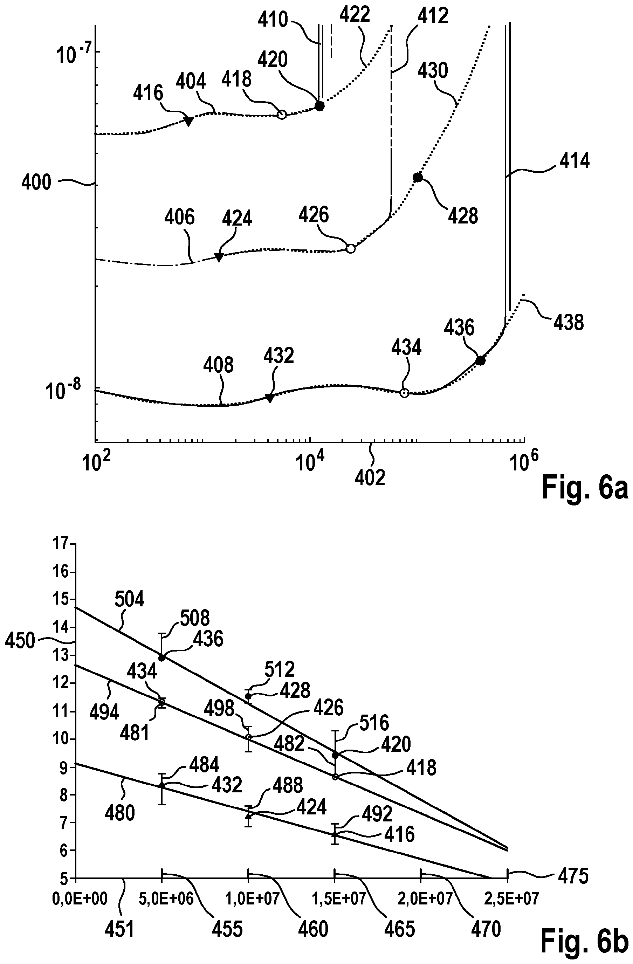

Figur 6a zeigt die Verläufe 404, 406 und 408 von Leckstrommessungen $Pb_{1.3}(Zr_{0.52} Ti_{0.48})O_3Ni_{0.005}$ als dielektrische Schicht eines Halbleiterbauelements, welches im Folgenden als Ausführungsbeispiel 4 bezeichnet wird. Die Herstellung von Ausführungsbeispiel 4 erfolgte analog zu Ausführungsbeispiel 1, jedoch wurde die dielektrische Schicht mit einer Target-Zusammensetzung von $Pb_{1.3}(Zr_{0.52} Ti_{0.48})O_3Ni_{0.005}$ abgeschieden.

Die in Figur 6a gezeigten Verläufe des Leckstroms wurden bei unterschiedlichen Betriebsspannungen und konstanter Betriebstemperatur von 150°C gemessen. Hierbei ist auf der X-Achse 402 die Zeit logarithmisch in der Einheit Sekunden und auf der Y-Achse 400 der Leckstrom in der Einheit Ampere logarithmisch aufgetragen. Der Leckstromverlauf 408 wurde bei einer Betriebsspannung von 5 Volt, der Verlauf 406 bei einer Betriebsspannung von 10 Volt und der Verlauf 404 bei einer Betriebsspannung von 15 Volt gemessen. Die Messungen wurden bis zu einem jeweiligen dielektrischen Durchbruch 410, 412 und 414 der dielektrischen Schicht durchgeführt. Die gute Übereinstimmung von der angewandten Thermionic-Emission-Diffusion Theorie, sowie einer durch mobile Defekte zeitlich veränderlichen

effektiven Barrierenhöhe $_{mit\ den}$ Messkurven, ist durch den Vergleich der gemessenen Stromverläufe 404, 406 und 408 mit den zugehörigen Modellkurven 422, 430 und 438 erkennbar.

Die in dem Leckstromverlauf 408 gekennzeichneten Punkte 432, 434 und 436 stellen die, analog des auf Figur 1a und 1b für die Ausführungsbeispiele 1 bis 3 beschriebenen Verfahrens, ermittelten charakteristischen Zeitkonstanten $\tau_g, \tau_h$ und $\tau_j$ für diesen Verlauf dar. Entsprechend stellen die in dem Leckstromverlauf 406 gekennzeichneten Punkte 424, 426 und 428 die ermittelten charakteristischen Zeitkonstanten $\tau_g$, $\tau_h$ und $\tau_j$ für diesen Verlauf dar. Des Weiteren stellen die in dem Leckstromverlauf 404 gekennzeichneten Punkte 416, 418 und 420 die ermittelten charakteristischen Zeitkonstanten $\tau_g$, $\tau_h$ und $\tau_j$ für diesen Verlauf dar. Jeder charakteristischen Zeitkonstante $\tau_g$, $\tau_h$ und $\tau_j$ ist bei den vorliegenden Messungen jeweils einer der in der dielektrischen Schicht vorliegende Defektart g, h und j zugeordnet.

Figur 6b zeigt die Verläufe des Logarithmus der Zeitkonstanten $\tau_i$ der vorliegenden Defektarten geteilt durch Sekunden in Abhängigkeit des elektrischen Feldes. Auf der X-Achse 451 ist hierbei das elektrische Feld in der Einheit Volt pro Meter und auf der Y-Achse 450 ist der natürliche Logarithmus der charakteristischen Zeitkonstanten $\tau_i$ einheitenlos aufgetragen. Der X-Achsenabschnitt 455 kennzeichnet hierbei das elektrische Feld, welches bei einer Betriebsspannung von 5 Volt an der dielektrischen Schicht anliegt. In einer Vertikalen durch diesen Achsenabschnitt 455 finden sich entsprechend die aus Figur 6a identifizierten charakteristischen Zeitkonstanten 432, 434 und 436 des Leckstromverlaufs 408 mit der jeweiligen Streubreite der Messdaten 481, 484 und 508 wieder. Der X-Achsenabschnitt 460 kennzeichnet das elektrische Feld, welches bei einer Betriebsspannung von 10 Volt an der dielektrischen Schicht anliegt. In einer Vertikalen durch diesen Achsenabschnitt 460 finden sich entsprechend die aus Figur 6a identifizierten charakteristischen Zeitkonstanten 424, 426 und 428 des Leckstromverlaufs 406 mit der jeweiligen Streubreite der Messdaten 488, 498 und 512 wieder. Der X-Achsenabschnitt 465 kennzeichnet das elektrische Feld, welches bei einer Betriebsspannung von 15 Volt an der dielektrischen Schicht anliegt. In einer Vertikalen durch diesen Achsenabschnitt 465 finden sich entsprechend die aus Figur 6a identifizierten charakteristischen Zeitkonstanten 416, 418 und 420 des Leckstromverlaufs 404 mit der jeweiligen Streubreite der Messdaten 492, 482 und 516 wieder.

Entsprechend Formel (10.3) ergeben sich für die Defektarten g, h und j Geraden 480, 494 und 504 mit den Steigungen $m_g$, $m_h$, und $m_j$, welche für ein konstantes $a_0 = 3{,}1$nm ganzzahlige Defektladungen $N_{q,g}=2$, $N_{q,h}=3$ und $N_{q,j}=4$ ergeben. Die Geraden 480, 494 und 504 sind entlang der Y-Achse verschoben durch die von $a_0$ abhängigen Konstanten $K_g$, $K_h$ und $K_j$.

## Patentansprüche

1. Halbleiterbauelement (200), umfassend

    - wenigstens eine dielektrische Schicht (230), und
    - wenigstens eine erste (202) und eine zweite Elektrode (201),

    wobei wenigstens zwei voneinander unterschiedliche Defektarten (212, 215, 217) in der dielektrischen Schicht (230) vorliegen, wobei sich die wenigstens zwei unterschiedlichen Defektarten (212, 215, 217) in Abhängigkeit einer zwischen der ersten (202) und zweiten Elektrode (201) angelegten Betriebsspannung und einer vorliegenden Betriebstemperatur entlang lokalisierter Defektzustände (235) mit jeweils einem mittleren effektiven Abstand ao (210) in Richtung einer der beiden Elektroden (201, 202) bewegen, **dadurch gekennzeichnet, dass** gilt

$$a_0\ (210) > 3{,}2\ \text{nm}.$$

2. Halbleiterbauelement (200) nach Anspruch 1, **dadurch gekennzeichnet, dass** gilt $a_0$ (210)> 3,24 nm.

3. Halbleiterbauelement (200) nach einem der Ansprüche 1 oder 2, **dadurch gekennzeichnet, dass** wenigstens drei voneinander unterschiedliche Defektarten (212, 215, 217) in der dielektrischen Schicht (230) vorliegen.

4. Halbleiterbauelement (200) nach einem der Ansprüche 1 bis 3, **dadurch gekennzeichnet, dass** die dielektrische Schicht (230) als polykristallines oxidisches high-k Dielektrikum, insbesondere als PZT-Schicht oder KNN-Schicht ausgebildet ist.

5. Halbleiterbauelement (200) nach Anspruch 4, **dadurch gekennzeichnet, dass** die dielektrische Schicht (230) als gesputterte PZT-Schicht ausgebildet ist.

6. Halbleiterbauelement (200) nach Anspruch 5, **dadurch gekennzeichnet, dass** die gesputterte PZT-Schicht bei einer Abscheidetemperatur von kleiner als 500°C gesputtert ist.

7. Halbleiterbauelement (200) nach einem der Ansprüche 5 oder 6, **dadurch gekennzeichnet, dass** die gesputterte PZT-Schicht eine Zusammensetzung von $Pb_{1.3}(Zr_{0.52}Ti_{0.48})O_3$ aufweist.

**Claims**

1. Semiconductor component (200), comprising

   - at least one dielectric layer (230), and
   - at least one first (202) and one second electrode (201),

     wherein at least two mutually different defect types (212, 215, 217) are present in the dielectric layer (230), wherein depending on an operating voltage applied between the first electrode (202) and the second electrode (201) and depending on an operating temperature present, the at least two different defect types (212, 215, 217) move along localized defect states (235) spaced apart by in each case a mean effective distance $a_0$ (210) in the direction of one of the two electrodes (201, 202), **characterized in that** it holds true that $a_0$ (210) > 3.2 nm.

2. Semiconductor component (200) according to Claim 1, **characterized in that** it holds true that $a_0$ (210) > 3.24 nm.

3. Semiconductor component (200) according to either of Claims 1 and 2, **characterized in that** at least three mutually different defect types (212, 215, 217) are present in the dielectric layer (230).

4. Semiconductor component (200) according to any of Claims 1 to 3, **characterized in that** the dielectric layer (230) is embodied as a polycrystalline oxidic high-k dielectric, in particular as a PZT layer or a KNN layer.

5. Semiconductor component (200) according to Claim 4, **characterized in that** the dielectric layer (230) is embodied as a sputtered PZT layer.

6. Semiconductor component (200) according to Claim 5, **characterized in that** the sputtered PZT layer is sputtered at a deposition temperature of less than 500°C.

7. Semiconductor component (200) according to either of Claims 5 and 6, **characterized in that** the sputtered PZT layer has a composition of $Pb_{1.3}(Zr_{0.52}Ti_{0.48})O_3$.

**Revendications**

1. Composant semi-conducteur (200), comprenant

   - au moins une couche diélectrique (230), et
   - au moins une première (202) et une deuxième électrode (201),
   au moins deux types de défauts différents l'un de l'autre (212, 215, 217) étant présents dans la couche diélectrique (230), les au moins deux types de défauts différents (212, 215, 217) se déplaçant en fonction d'une tension de fonctionnement appliquée entre la première (202) et la deuxième (201) électrodes et d'une température de fonctionnement présente, le long d'états de défauts localisés (235) avec respectivement une distance effective moyenne $a_0$ (210) en direction de l'une des deux électrodes (201, 202), **caractérisé en ce que**

$$a_0 \; (210) \; > \; 3{,}2 \; nm.$$

2. Composant semi-conducteur (200) selon la revendication 1, **caractérisé en ce que** $a_0$ (210) > 3,24 nm.

3. Composant semi-conducteur (200) selon l'une quelconque des revendications 1 ou 2, **caractérisé en ce qu'**au moins trois types de défauts (212, 215, 217) différents les uns des autres sont présents dans la couche diélectrique (230).

4. Composant semi-conducteur (200) selon l'une quelconque des revendications 1 à 3, **caractérisé en ce que** la couche diélectrique (230) est configurée sous forme de diélectrique high-κ polycristallin oxydique, notamment sous forme de couche de PZT ou de couche de KNN.

5. Composant semi-conducteur (200) selon la revendication 4, **caractérisé en ce que** la couche diélectrique (230) est configurée sous forme de couche de PZT pulvérisée.

6. Composant semi-conducteur (200) selon la revendication 5, **caractérisé en ce que** la couche de PZT pulvérisée est pulvérisée à une température de dépôt inférieure à 500 °C.

7. Composant semi-conducteur (200) selon l'une quelconque des revendications 5 ou 6, **caractérisé en ce que** la couche de PZT pulvérisée présente une composition de $Pb_{1,3}(Zr_{0,52}Ti_{0,48})O_3$.

Fig. 1a

Fig. 1b

Fig. 2a

Fig. 2b

Fig. 3

Fig. 4a

Fig. 4b

$$t_0 < t_1 < t_{krit}$$

Fig. 4c

$$t_1 < t_2 < t_{krit}$$

Fig. 4d

$t_2 < t_{krit} < t_3$

Fig. 5

Fig. 6a

Fig. 6b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011074889 A1

- EP 3306687 A1

**In der Beschreibung aufgeführte Nicht-Patentliteratur**

- **C. A. RANDALL ; R. MAIER ; W. QU ; K. KOBAYASHI ; K. MORITA ; Y. MIZUNO ; N. INOUE ; T. OGUNI.** Improved reliability predictions in high permittivity dielectric oxide capacitors under high dc electric fields with oxygen vacancy induced electromigration. *Journal of Applied Physics,* 2013, vol. 113, 014101

- **CHAKRABORTI P et al.** XPS depth profiling and leakage properties of anodized titania dielectrics and their application in high-density capacitors. *J. Mater. Sci.,* 2015, vol. 50, 7600-7609